# FASCICULE DE BREVET EUROPEEN

(11) **EP 3 463 868 B1**
(45) Date de publication et mention de la délivrance du brevet: **20.09.2023**
(21) Numéro de dépôt: 17732501.6
(22) Date de dépôt: 24.05.2017
(51) Int. Cl.: B32B 17/10, B60Q 3/208, B60Q 3/76, F21V 33/00, C03C 27/12, B62D 25/06, B60Q 1/26

(54) **TOIT VITRE FEUILLETE LUMINEUX DE VEHICULE, VEHICULE L'INCORPORANT ET FABRICATION**
LAMINIERTES BELEUCHTETES GLASDACH FÜR EIN FAHRZEUG, DAMIT AUSGERÜSTETES FAHRZEUG, UND HERSTELLUNG DESSELBEN
ILLUMINATED LAMINATED SUNROOF FOR VEHICLE, VEHICLE INCORPORATING SAME, AND MANUFACTURE

(30) Priorité: 26.05.2016 FR 1600850
(43) Date de publication de la demande: 10.04.2019
(73) Titulaire: SAINT-GOBAIN GLASS FRANCE, 92400 Courbevoie (FR)
(72) Inventeur: BAUERLE, Pascal, 80700 Roye (FR)
(74) Mandataire: Saint-Gobain Recherche
(86) Numéro de dépôt international: PCT/FR2017/051286
(87) Numéro de publication internationale: WO 2017/203170

(56) Documents cités:
- WO-A1-2007/045786
- WO-A1-2016/001508
- WO-A1-2016/079459
- US-A1- 2010 179 725

## Description

L'invention concerne un toit vitré feuilleté lumineux de véhicule ainsi qu'un véhicule comportant un tel toit et la fabrication d'un tel toit.

Il existe de plus en plus de toits automobiles vitrés, certains capables d'apporter la lumière d'ambiance. La lumière provient directement des diodes électroluminescentes insérées au sein du vitrage feuilleté. Le document WO2016079459 qui représente de l'art antérieur selon l'article 54(3) CBE concerne un vitrage de signalisation lumineuse formant pare-brise de véhicule feuilleté comportant un vitrage extérieur, un intercalaire de feuilletage en matière polymérique d'épaisseur e1 d'au plus 0,8mm, un vitrage intérieur et un ensemble de diodes sur une face dite avant d'une carte PCB, les diodes étant d'épaisseur e2 et la carte PCB étant d'épaisseur e'2, l'ensemble carte PCB et diodes étant d'épaisseur et2 égale ou moins que e1 et chaque diode émettant en direction du verre intérieur. Pour chacune des diodes, l'intercalaire de feuilletage comprend une ouverture traversante entourant la tranche de la diode.

Le document WO2013189794 dans le mode de réalisation en relation avec la figure 1 comporte un toit automobile vitré lumineux comprenant :
- un vitrage feuilleté comportant :
   - un premier vitrage formant vitrage extérieur avec des première et deuxième faces principales souvent appelées F1 et F2
   - un intercalaire de feuilletage sous forme de trois feuillets de PVB
   - un deuxième vitrage formant vitrage intérieur avec des troisième et quatrième faces principales souvent appelées F3 et F4
   les deuxième et troisième faces étant les faces internes du vitrage
- un ensemble de diodes sur un support mince qui est une lame de verre comportant un circuit d'alimentation électrique en couche d'oxyde conducteur
chaque diode ayant une face émettrice émettant en direction du verre intérieur, le feuillet central de l'intercalaire de feuilletage ayant une ouverture traversante ménagée tout autour de la lame de verre pour son intégration.

Le taux de rebut de ce vitrage peut être amélioré et par la même le cout de fabrication réduit. L'invention vise ainsi un toit vitré plus robuste, voire même plus compact et/ou simple à fabriquer.

A cet effet, la présente demande a pour premier objet un toit vitré feuilleté lumineux de véhicule notamment automobile ou encore de transport en commun comprenant :
- un vitrage feuilleté comportant :
   - un premier vitrage (transparent), en verre minéral, éventuellement clair, extraclair ou de préférence teinté notamment gris ou vert, de préférence bombé, destiné à être le vitrage extérieur, avec des première et deuxième faces principales respectivement dites face F1 et face F2, pour le véhicule automobile, d'épaisseur de préférence d'au plus 2,5mm, même d'au plus 2,2mm - notamment 1,9mm, 1,8mm, 1,6mm et 1,4mm- ou même d'au plus1,3mm ou d'au plus 1mm
   - un deuxième vitrage (transparent), en verre minéral, de préférence bombé et de préférence clair ou extraclair voire teinté (moins que le premier vitrage), vitrage destiné à être le vitrage intérieur, avec des troisième et quatrième faces principales respectivement face F3 et face F4, et, pour le véhicule automobile, d'épaisseur de préférence inférieure à celle du premier vitrage, même d'au plus 2mm - notamment 1,9mm, 1,8mm, 1,6mm et 1,4mm- ou même d'au plus 1,3mm ou de moins de 1,1mm ou encore de moins de 0,7mm notamment d'au moins 0,2mm, l'épaisseur totale des premier et deuxième vitrages étant de préférence strictement inférieure à 4mm, même à 3,7mm, le deuxième vitrage pouvant être trempé chimiquement,
   - entre les faces F2 et F3 qui sont les faces internes du vitrage feuilleté un intercalaire de feuilletage, éventuellement clair, extraclair ou même teinté notamment gris ou vert (teinté surtout si à ouvertures traversantes), en matière polymérique de préférence thermoplastique et mieux encore en polyvinylbutyral (PVB), film intercalaire de feuilletage (feuillet unique, feuillet composite) ayant une face principale FA côté face F2 et une face principale FB côté face F3, la face FA pouvant être en contact adhésif avec la face F2 (nue ou revêtue d'un revêtement) et la face FB être en contact adhésif avec la face F3 (nue ou revêtue d'un revêtement), intercalaire de feuilletage d'épaisseur E_{A} entre la face FA et FB -qui pour le véhicule automobile- est de préférence d'au plus 1,8mm, mieux d'au plus 1,2mm et même d'au plus 0,9mm (et mieux d'au moins 0,3mm et même d'au moins 0,6mm), notamment en retrait du chant du premier vitrage d'au plus 2mm et en retrait du chant du deuxième vitrage d'au plus 2mm, notamment étant un premier feuillet acoustique et/ou teinté
- un ensemble de N>1 diodes électroluminescentes inorganiques, chaque diode comportant au moins une puce semi-conductrice de préférence dans une enveloppe (packaging) chaque diode étant apte à émettre en direction de la face F3, -et chaque diode ayant notamment une tranche et une surface avant (dans le plan de la face avant du packaging) et même de préférence diode ayant une largeur W4 (dimension maximale normale à l'axe optique) d'au plus 10mm et même d'au plus 8mm et même d'au plus 6mm, chaque diode étant d'épaisseur e2 submillimétrique et notamment supérieure à 0,2mm

Ledit intercalaire de feuilletage est pourvu entre la face FA et la face FB d'un ensemble de M>1 ouvertures qui sont traversantes ou formant trous borgnes, chaque ouverture étant de préférence de largeur W_{A} (supérieure ou égale à celle de la diode dans l'ouverture) d'au plus 20mm et même d'au plus 15mm.

Chaque diode est associée à une ouverture traversante ou un trou borgne (donc une ouverture traversante ou borgne par diode donc ouverture individuelle) logeant (entourant la tranche de) la diode.

En particulier :
- lorsque l'ouverture est traversante et la face FB en contact avec la face F3, (la surface avant de) la diode est en retrait de préférence de la face F3
- lorsque l'ouverture est traversante, lorsqu'une diode est en montage inversé et la face FA est en contact avec la face F3, la diode est de préférence en retrait de la face F2 (de la face FA),
- lorsque le trou est borgne l'épaisseur restante dite de fond Hf est de préférence d'au plus 0,3mm et/ou d'au moins 0,1mm ou 0,2mm.

Aussi, la présente invention propose des découpes locales de l'intercalaire de feuilletage dédiées aux diodes. En particulier, on évite la découpe totale tout autour du support de diode(s) (carte PCB) comme pratiqué dans l'art antérieur et qui augmente le risque de mauvais assemblage (bulles, délamination, défauts esthétiques).

En particulier le support de diodes est flexible et assez mince pour ne pas ajouter obligatoirement un feuillet type PVB côté arrière du support.

L'intercalaire de feuilletage est de préférence au plus près des diodes et de préférence en tenant compte de la tolérance de positionnement des diodes lors de la découpe choisie de préférence plus large que la largeur des diodes (même si l'intercalaire a de la souplesse).

L'intercalaire de feuilletage notamment PVB avec ouverture traversante (ou borgne) entre la face FA et FB peut être en surépaisseur la plus faible possible par rapport aux diodes pour ne pas risquer de générer trop de bulles d'air.

On peut préférer utiliser une unique feuille (de PVB) pour l'intercalaire pour des raisons économiques (cout matière et simplement une série de découpes locales à faire).

L'usage d'une seule feuille (de PVB) de préférence d'épaisseur standard 0,78mm ou 0,81mm (pour davantage de sécurité plutôt que 0,38mm) est rendue possible par le choix de nouvelles diodes de puissance ultraminces, très récemment disponibles sur le marché.

L'intercalaire de feuilletage peut avoir entre la face F2 et F3 une épaisseur totale E_{T} d'au plus 1,8mm, mieux d'au plus 1,2mm et même d'au plus 0,9mm (et mieux d'au moins 0,3mm et même d'au moins 0,6mm), sous forme d'un feuillet unique (avec la ou les ouvertures, par exemple en PVB ou notamment composite) ou de plusieurs feuillets (de préférence deux feuillets voire au plus trois feuillets), notamment un feuillet acoustique clair ou teinté (de préférence tricouche ou même quadricouche ou plus). Ces feuillets (premier feuillet avec la ou les ouvertures, deuxième feuillet) peuvent être en contact dans une zone (hors zone de support à diode(s) éventuel) et/ou distants ou espacés (séparés par un film plastique, notamment PET, couvrant etc). E_{T} peut être la somme des épaisseurs de feuillets en contact ou disjoints.

Dans un mode de réalisation préféré :
- l'épaisseur de l'intercalaire de feuilletage entre la face FA et la face FB est subcentimétrique, de préférence entre 0,7 et 0,9mm,
- l'épaisseur totale de PVB Eₜₒₜ entre F2 et F3 est subcentimétrique.

L'intercalaire de feuilletage (notamment feuillet ou partie avec la ou les ouvertures) peut être un PVB acoustique notamment tricouche.

En particulier, dans un mode de réalisation, l'intercalaire de feuilletage est formé à partir d'un feuillet unique (clair, extraclair ou teinté), de préférence PVB, avec les ouvertures de préférence traversantes, et la face arrière du support de diode(s) est contre ou collée à la face F2. Le feuillet unique peut être un PVB acoustique.

Dans un autre mode de réalisation, un feuillet thermoplastique, de préférence PVB, est présent entre la face arrière du support de diode(s) et la face F2 ou la face F3 en montage inversé, de préférence feuillet d'épaisseur d'au plus 0,4mm, ou acoustique notamment teinté si côté face F2.

On peut utiliser un premier feuillet de préférence PVB avec les ouvertures traversantes voire les trous borgnes et on rajoute un deuxième feuillet de préférence PVB (qui peut être plus mince que le premier feuillet) côté face arrière du support de diode(s). Ce deuxième feuillet est de préférence de même étendue que le feuillet avec les ouvertures traversantes. Ce deuxième feuillet peut être d'épaisseur d'au plus 0,38mm et même d'au plus 0,2mm, notamment clair, extraclair ou teinté. Le premier feuillet lui peut être un PVB acoustique, de préférence clair (extraclair), de préférence entre 0,6 et 0,9mm.

Inversement le deuxième feuillet de préférence PVB peut être d'épaisseur entre 0,7 et 0,9mm et même d'épaisseur supérieure ou égale au premier feuillet de préférence PVB. En particulier le premier feuillet de préférence PVB est clair et le deuxième feuillet est un PVB acoustique notamment teinté.

Comme précité, on peut utiliser deux (ou plusieurs) feuillets (de préférence de PVB) comme indiqué pour un renfort mécanique. Par exemple :
- un premier feuillet par exemple teinté (de préférence de PVB par exemple acoustique) avec les ouvertures traversantes ou borgnes d'épaisseur d'au plus 0,4mm,
- un deuxième feuillet, de préférence PVB, d'épaisseur d'au plus 0,4mm, et même d'au plus 0,2mm, notamment de 0,19mm.

Si les diodes (et le support de diode(s)) sont suffisamment minces on peut même inverser les épaisseurs. Par exemple :
- un premier feuillet (de préférence de PVB) avec les ouvertures traversantes ou borgnes d'épaisseur d'au plus 0,4mm et même d'au plus 0,2mm,
- un deuxième feuillet (de préférence de PVB) d'épaisseur d'au plus 0,4mm.

Dans un mode de réalisation préféré les parois d'une ou des ouvertures traversantes ou des trous borgnes sont espacés d'au plus 0,5mm mieux d'au plus 0,2mm voire 0,1mm de la tranche de la diode ou de diodes dudit groupe y logeant et même est en contact avec la tranche de la diode ou de diodes dudit groupe y logeant. L'ouverture ou le trou peut être remplie par la diode (ou le groupe de diodes).

Une diode peut être de type « chip on board » ou encore tout préférentiellement un composant monté en surface (SMD en anglais) comportant alors une enveloppe périphérique (souvent dénommée « packaging »).

Dans un mode de réalisation préféré, chaque diode, de préférence de puissance, étant un composant électronique incluant au moins une puce semi-conductrice, et est équipée d'une enveloppe périphérique (souvent dénommée « packaging »), polymérique ou céramique, encapsulant la tranche du composant électronique (et définissant la tranche de la diode), entourant la puce semi-conductrice.

L'enveloppe peut correspondre à l'épaisseur maximale (hauteur) e2 de la diode. L'enveloppe est par exemple en époxy. Une enveloppe polymérique peut éventuellement se tasser (l'épaisseur finale après feuilletage peut être inférieure à l'épaisseur initiale) lors du feuilletage. L'enveloppe (polymérique) peut être opaque.

L'enveloppe (monolithique ou en deux pièces) peut comprendre une partie formant embase porteuse de la puce et une partie formant réflecteur évasée en s'éloignant de l'embase plus haute que la puce, et contenant une résine de protection et/ une matière à fonction de conversion de couleur. On peut définir la surface avant comme la surface de cette matière couvrant la puce en retrait ou au niveau de la surface « avant» du réflecteur.

Dans un mode de réalisation préféré, chaque diode, de préférence de puissance, étant un composant électronique incluant la puce semi-conductrice, et est équipée d'une enveloppe périphérique (souvent dénommée « packaging »), polymérique ou céramique, encapsulant la tranche du composant électronique, en saillie et entourant la puce semi-conductrice, -enveloppe définissant la tranche de la diode et la surface avant de la diode)- l'intercalaire de feuilletage (par fluage lors du feuilletage) s'étend jusqu'à être entre la surface dite avant de l'enveloppe et la face F3 sans aller jusqu'à la face avant de la diode (face émettrice de la puce ou face de l'ensemble puce et matière couvrante de protection ou à fonction de conversion de longer d'onde. éventuellement le composant électronique comporte une partie dite inférieure porteuse de la ou des puce-semi-conductrices et avec une partie supérieure évasée vers face F3

L'intercalaire de feuilletage s'étend jusqu'à être entre ladite surface avant de l'enveloppe et la face F3 sans être en contact avec la face émettrice de la puce, la largeur de l'ouverture W' dans le plan de la surface avant étant inférieure à W et supérieure à la largeur W'2 de la face émettrice de la puce.

L'enveloppe peut correspondre à l'épaisseur maximale (hauteur) e2 de la diode. L'enveloppe est par exemple en époxy. Une enveloppe polymérique peut éventuellement se tasser (l'épaisseur finale après feuilletage peut être inférieure à l'épaisseur initiale) lors du feuilletage. L'enveloppe (polymérique) peut être opaque.

La diode peut comprendre une résine de protection ou une matière à fonction de conversion de couleur, classiquement sur la puce semi-conductrice. La puce-semiconductrice peut être noyée dans une matière (résine, etc). L'enveloppe peut avoir un profil évasé en s'éloignant de la puce et l'espace entre la puce et l'enveloppe peut contenir une résine de protection ou une matière à fonction de conversion.

La diode (chip on board ou SMD) peut être dénuée d'élément optique (lentille etc) au-dessus de la puce-semi conductrice (noyée ou non dans de la matière) pour faciliter une compacité

Avant feuilletage, l'intercalaire de feuilletage (avec la ou les ouvertures traversantes ou borgnes) peut être espacé d'au plus 0,5mm mieux d'au plus 0,1mm de la tranche de la diode et après feuilletage, du fait du fluage l'intercalaire de feuilletage avec la ou les ouvertures traversantes borgnes peut être moins espacé et même en contact avec la tranche. Et - dans le cas d'une ou des ouvertures traversantes- l'intercalaire de feuilletage peut déborder sur la face avant du composant notamment en entourant la puce semi-conductrice, sans être en regard et/ou au contact de la face émettrice de la puce. Le ou les trous borgnes peuvent être remplis par la ou les diodes.

De préférence la ou les diodes sont des composants montés en surface sur la face avant d'un support de diode(s) et même la ou les diodes ont une émission lambertienne ou quasi lambertienne.

Dans un mode de réalisation préféré, l'épaisseur d'intercalaire de feuilletage, entre face FA et face FB va de 0,7 à 0,9mm (un feuillet unique ou un premier feuillet et un deuxième feuillet) est en PVB, les diodes sont des composants montés en surface sur la face avant du support de diodes dont l'épaisseur e'2 est d'au plus (ou inférieur à) 0,2mm mieux d'au plus 0,15mm et même d'au plus 0,05mm.

La largeur du support de diode(s) tel que la carte PCB est de préférence d'au plus 5cm, mieux d'au plus 2cm, et même d'au plus 1cm. La largeur (ou longueur) d'une diode avec une seule puce semi conductrice, généralement diode de forme carrée, est de préférence d'au plus 5mm. La longueur d'une diode avec une pluralité des puces semi- conductrices (typiquement entourées par l'enveloppe), généralement de forme rectangulaire, est de préférence d'au plus 20mm mieux d'au plus 10mm.

Notamment dans le cas d'un feuillet unique -avec les ouvertures traversantes ou les trous borgnes- notamment un PVB éventuellement acoustique, teinté ou clair-, le support de diode(s) (suffisamment souple pour s'adapter au vitrage feuilleté bombé) peut être collé ou plaqué contre la face F2 ou la face F3 en montage inversé, e'2 est d'au plus 0,15mm et même d'au plus 0,1mm, notamment collage par un adhésif (colle ou de préférence adhésif double face), d'épaisseur e3 avec e3≤0,1mm, mieux e3≤0,05mm -même tel que e3+e'2 est d'au plus 0,15mm mieux d'au plus 0,1mm-.

Avec cet adhésif on préfère e3+et2≤e1 (surtout si présent en face arrière du PCB dans la zone des diodes).

Le collage est sur toute la longueur du support ou ponctuel (un ou plusieurs points), dans zone à diodes et/ou hors diodes. L'adhésif en périphérie peut faire une étanchéité à l'eau liquide.

Le support de diode(s) peut être local et éventuellement avec des ouvertures traversantes (pour le rendre plus discret). En particulier, le support de diodes comporte une première partie porteuse des diodes qui est évidée.

Le toit peut comprendre un feuillet, en particulier de l'intercalaire de feuilletage, en matière thermoplastique entre la face arrière du support de diode(s) et la face F2 ou la face F3 en montage inversé.

L'intercalaire de feuilletage formé à partir d'un ou plusieurs films -entre la face FA et FB et/ou feuillet en face arrière et/ou encore feuillet entre la face FB et la face F3- peut être en en polyvinylbutyral (PVB), en polyuréthane (PU), en copolymère éthylène/acétate de vinyle (EVA), ayant par exemple une épaisseur entre 0,2mm et 1,1mm.

On peut choisir un PVB classique comme le RC41 de Solutia ou d'Eastman.

L'intercalaire de feuilletage entre la face FA et FB et/ou feuillet en face arrière et/ou encore feuillet entre la face FB et la face F3-peut comprendre au moins une couche dite centrale en matériau plastique viscoélastique aux propriétés d'amortissement vibro-acoustique notamment à base de polyvinylbutyral (PVB) et de plastifiant, et l'intercalaire, et comprenant en outre deux couches externes en PVB standard, la couche centrale étant entre les deux couches externes. Comme exemple de feuillet acoustique on peut citer le brevet EP0844075. On peut citer les PVB acoustiques décrits dans les demandes de brevet WO2012/025685, WO2013/175101, notamment teinté comme dans le WO2015079159.

De préférence, le toit présente l'une au moins des caractéristiques suivantes :
- l'ouverture de préférence traversante est dans une épaisseur de PVB (un ou plusieurs feuillets, avec interface discernable notamment)
- l'ouverture de préférence traversante est dans un intercalaire de feuilletage acoustique notament PVB, en particulier tricouche ou quadricouche,
- l'ouverture de préférence traversante est dans un intercalaire de feuilletage teinté, notamment PVB (notamment masquant un peu le support de diode(s)),
- l'ouverture est dans une matière composite (multifeuillets) : PVB/film plastique transparent ou encore PVB/film plastique transparent/PVB, ledit film plastique, notamment un PET, d'épaisseur submillimétrique notamment d'au plus 0,1mm ou d'au 0,15mm ou d'au plus 0,05mm, étant de préférence (transparent et) porteur d'un revêtement fonctionnel (couche électroconductrice notamment transparente) :basse émissivité ou de contrôle solaire et/ou encore chauffant, en particulier le/chaque ouverture est borgne (individuelle ou commune) et est dans l'un des PVB et distant du revêtement fonctionnel,
- l'espacement entre ouvertures traversantes ou borgnes est d'au moins 0,1 mm ou mieux d'au moins 0,2mm et de préférence d'au plus 50cm pour une fonction liseuse
- l'espacement entre diodes d'ouvertures traversantes ou borgnes distinctes est d'au moins 0,1 mm ou mieux d'au moins 0,2mm
- l'espacement entre diodes dans une ouverture traversante ou borgne commune est d'au moins 0,1 mm ou mieux d'au moins 0,2mm et même d'au plus 1mm.

Naturellement, la face FB de l'intercalaire avec la ou les ouvertures ou un autre feuillet de PVB peut être en contact direct avec la face F3 (respectivement face F2 en montage inverse de diode(s)) ou avec un revêtement fonctionnel classique sur cette face F3 (respectivement face F2 en montage inverse), notamment un empilement de couches minces (incluant une ou des couches argent) tel que : couche chauffante, antennes, couche de contrôle solaire ou basse émissivité ou une couche décor ou de masquage (opaque) comme un émail généralement noir.

Le verre de préférence interne, notamment mince d'épaisseur de moins de 1,1mm, peut être de préférence trempé chimiquement. Il est de préférence clair. On peut citer les exemples des demandes WO2015/031594 ou WO2015066201.

Dans la présente invention les termes « trou borgne » ou « ouverture borgne » désignent la même chose.

Les diodes sont de préférence des diodes de puissance qui sont en fonctionnement sous alimentées électriquement en courant, de préférence avec un facteur d'au moins 10 et même d'au moins 20 (donc intensité /10 voire intensité/20) notamment de façon à maintenir une température inférieure à la température de ramollissement du matériau polymérique de l'intercalaire de feuilletage, en particulier d'au plus 130°C, mieux d'au plus 120°C et même d'au plus 100°C.

Ces diodes garantissent une excellente efficacité sans trop chauffer.

Par exemple pour des diodes alimentées en courant à 1A on choisit entre 50 et 100mA.

Les diodes inorganiques sont par exemple à base de phosphure de gallium, de nitrure de gallium, de gallium et d'aluminium.

Le support de diode(s) (carte PCB) peut être suffisamment souple (flexible) pour s'adapter aux courbures du vitrage feuilleté bombé.

Dans un mode de réalisation, le support de diode(s) comporte un film en matière plastique de préférence transparent, de préférence en poly(éthylène téréphtalate) ou PET ou en polyimide, pourvue de pistes conductrices, notamment métalliques (cuivre etc) ou en oxyde conducteur transparent, de préférence transparentes et équipée des diodes montées en surface. Les pistes conductrices sont imprimées ou déposées par toute autre méthode de dépôt par exemple dépôt physique en phase vapeur. Les pistes conductrices peuvent aussi être des fils. On préfère que les pistes conductrices et le film soient transparents lorsqu'ils sont visibles c'est-à-dire qu'ils ne sont pas masquées par un élément (couche) de masquage (tel qu'un émail voire une peinture etc) notamment en face F4 ou F3. Les pistes conductrices peuvent être transparentes de par la matière transparente ou par leur largeur suffisamment fine pour être (quasi) invisibles.

Des films de polyimide ont une tenue en la température plus élevée par rapport à l'alternative PET ou même PEN (poly(naphtalate d'éthylène).

Le support de diode(s) peut être local (par exemple couvrir au plus 20% ou au plus 10% de la surface du vitrage feuilleté) ou couvrir essentiellement les faces F2 et F3 et de préférence étant porteur d'un revêtement fonctionnel basse émissivité ou de contrôle solaire et/ou encore chauffant.

De préférence, le support de diode(s) seul ou associé à un connecteur plat s'étend au moins jusqu'à la tranche du vitrage feuilleté, et de préférence dépasse de la tranche, par exemple le support de diode(s) comporte avec une première partie avec la ou les diodes et une partie moins large débouchant du vitrage, et entre la face arrière du support de diode(s) et la face F2, est logé un adhésif étanche à l'eau liquide d'épaisseur d'au plus 0,1mm et mieux d'au plus 0,05mm, notamment un adhésif double face. On préfère un tel adhésif à une solution de surmoulage. Il peut s'agir de l'adhésif de préférence transparent utilisé pour fixer (tout) le support de diode(s).

Le support de diode(s) peut comporter :
- une première partie (rectangulaire) porteuse de la ou des diodes,
- et une deuxième partie pour la connectique (rectangulaire) débouchant et même dépassant sur la tranche du vitrage feuilleté.

Cette deuxième partie peut être (beaucoup) plus longue que la première partie et/ou moins large que la première partie.

De préférence, la première partie est d'au moins large de 2mm. Le support de diode(s) peut être en forme coudée notamment en L.

Le support de diode(s) peut être associé à un connecteur plat s'étendant jusqu'à la tranche du vitrage feuilleté et même la dépassant. On préférence un connecteur flexible s'adaptant à la courbure du vitrage feuilleté, comportant un plastique par exemple PEN, polyimide. Le connecteur plat peut être de largeur (dimension le long de la tranche - de sortie-) inférieure ou égale à la dimension du support de diode(s) le long de la tranche - de sortie-.

Le vitrage peut comporter plusieurs groupes de diodes (et donc d'ouvertures de préférence traversantes) avec la même fonction ou des fonctions distinctes.

Les diodes (sur un support de diode(s)) peuvent émettre la même lumière ou une lumière de couleurs différente, de préférence pas en même temps.

Pour avoir une surface lumineuse plus grande et/ou des couleurs différentes on peut avoir -sur un même support de diode(s)- plusieurs rangées de diodes voire encore accoler deux support de diode(s) (au moins accoler les premières parties des supports de diode(s) avec diodes).

De préférence, ledit ensemble des diodes du toit vitré (de véhicule routier de préférence) formant l'une au moins des zones lumineuses suivantes:
- une zone lumineuse formant liseuse ou un éclairage d'ambiance, côté conducteur et/ou copilote ou passager(s) arrière(s),
- une zone lumineuse décorative
- une zone lumineuse comportant une signalétique notamment en lettre(s) et/ou pictogramme(s), en particulier pour la connectivité du réseau, côté co-pilote ou passager(s) arrière(s),

De préférence des diodes dudit ensemble forment une liseuse et sont de préférence dans une ouverture traversante (commune) ou des ouvertures traversantes et/ou sur le support de diodes entre la face F2 et la face FA.

De préférence la diode (seule ou une des diodes dudit ensemble) forme un indicateur lumineux d'un interrupteur tactile déporté côté face F3 et en regard de la diode, la diode formant ledit indicateur lumineux est de préférence sur le support de diodes comportant des diodes dudit ensemble -formant liseuse de préférence-entre la face F2 et la face FA.

Les diodes formant une liseuse (éclairage de lecture) sont le long d'un bord longitudinal ou latéral du toit :
- en (au moins) une rangée formant une bande lumineuse.
- en rond, ou en carré ou même en croix ou toute autre forme.

On peut avoir une couche diffusante ou formant un repère de la diode qui est un témoin lumineux d'un interrupteur (capacitif de préférence) d'un dispositif électrocommandable: diodes formant liseuse, valve optique (« SPD »), couche chauffante etc).

Le support de diode(s) peut être tout ou partie dans le clair de vitre, espacé ou non des bandes périphériques opaques (même formant cadre opaque) comme un émail de masquage (noir, foncé etc). Le plus souvent, il y a une couche opaque en face F2 et une couche opaque en face F4 voire F3. Leurs largeurs sont identiques ou distinctes.

La largeur Li d'une bande périphérique opaque en face F2 et/ou F3 et/ou F4 est de préférence d'au moins 10mm et même 15mm. Aussi, la longueur du support de diodes peut être supérieure à Li.

Le support de diode(s) (au moins la (première) partie avec la ou les diodes et/ou au moins la (deuxième) partie sans les diodes notamment pour la connectique , de préférence dépassant de la tranche du vitrage feuilleté) peut être agencé dans ou au voisinage de la région d'une couche opaque, notamment un émail (noir), le long d'un bord périphérique du vitrage feuilleté, généralement en face F2 et/ou face F4 ou encore en face F2 et/ou en face F3.

Aussi, dans un premier mode de réalisation, le support de diode(s) peut même être disposé dans une région du toit dans laquelle le verre extérieur est entièrement (ou partiellement) opaque par la couche opaque (la plus externe), comme un émail (noir), en F2. Cette couche opaque peut être dans cette région du toit une couche pleine (fond continu) ou une couche avec une ou des discontinuités (surfaces sans couche opaque) par exemple couche sous forme d'un ensemble de motifs géométriques (en rond, rectangle, carré etc),ou non, de taille identiques ou distinctes (de taille de plus ou plus petite en s'éloignant de la tranche et/ou motifs de plus ou plus espacés en s'éloignant de la tranche).

Dans ce premier mode de réalisation, la ou les diodes voire le support de diode(s) peut être visible uniquement à l'intérieur et donc masqué (de l'extérieur) par la couche opaque en face F2.

Alternativement ou cumulativement au premier mode de réalisation, le support de diode(s) (tout ou partie) peut être, disposé dans une région du toit dans laquelle le verre intérieur est opaque par une couche opaque (la plus interne) comme un émail (noir) de préférence en F4 voire en F3. Cette couche opaque comporte alors au moins une ou des épargnes (par un masque au dépôt ou par retrait notamment laser) au droit de chaque diode. Cette couche opaque par exemple est sous forme d'un ensemble de motifs opaques géométriques ou non (en rond, rectangle, carré etc), de taille identiques ou distinctes (de taille de plus ou plus petite et/ou avec motifs de plus ou plus espacés en s'éloignant de la tranche). Des zones entre les motifs opaques sont au droit des diodes.

Comme diodes on peut citer la gamme des OSLON BLACK FLAT vendue par OSRAM. Pour la lumière rouge, on peut citer comme diode vendue par OSRAM : OSLON BLACK FLAT Lx H9PP. Pour la lumière orange (ambre), on peut citer comme diode vendue par OSRAM : LCY H9PP. Pour la lumière blanche on peut citer comme diode vendue par OSRAM : LUW H9QP ou KW HxL531.TE où x est nombre de puces dans la diode (par exemple 4 ou 5).

Comme PCB flexible on peut citer la gamme des produits AKAFLEX^{®} (notamment PCL FW) de la société KREMPEL.

Dans un mode de réalisation du véhicule, il comporte au moins une unité de commande pour piloter les diodes et même au moins un capteur notamment pour détecter la luminosité. Une unité de commande pour piloter les diodes peut être dans le vitrage feuilleté, sur ou en dehors du support de diode(s).

De préférence le toit vitré selon l'invention répond aux spécifications actuelles automobiles en particulier pour la transmission lumineuse T_{L} et/ou la transmission énergétique T_{E} et/ou la réflexion énergétique R_{E} et/ou encore pour la transmission totale de l'énergie solaire TTS.

Pour un toit automobile, on préfère l'un ou les critères suivants :
- T_{E} d'au plus 10% et même de 4 à 6%,
- R_{E} (de préférence côté face F1) d'au plus 10%, mieux de 4 à 5%
- et TTS <30% et même <26%, même de 20 à 23%.

La T_{L} peut être faible par exemple d'au plus 10% et même de 1 à 6%.

Afin de limiter l'échauffement dans l'habitacle ou de limiter l'usage d'air conditionné, l'un des vitrages au moins (de préférence le verre extérieur) est teinté, et le vitrage feuilleté peut comporter également une couche de réfléchissant ou absorbant le rayonnement solaire, de préférence en face F4 ou en face F2 ou F3, en particulier une couche d'oxyde transparent électro-conducteur dite couche TCO (en face F4) ou même un empilement de couches minces comprenant au moins une couche TCO, ou d'empilements de couches minces comprenant au moins une couche d'argent (en F2 ou F3), la ou chaque couche d'argent étant disposée entre des couches diélectriques.

On peut cumuler couche (à l'argent) en face F2 et/ou F3 et couche TCO en face F4.

La couche TCO (d'un oxyde transparent électro-conducteur) est de préférence une couche d'oxyde d'étain dopé au fluor (SnO₂:F) ou une couche d'oxyde mixte d'étain et d'indium (ITO).

D'autres couches sont possibles, parmi lesquelles les couches minces à base d'oxydes mixtes d'indium et de zinc (appelées « IZO »), à base d'oxyde de zinc dopé au gallium ou à l'aluminium, à base d'oxyde de titane dopé au niobium, à base de stannate de cadmium ou de zinc, à base d'oxyde d'étain dopé à l'antimoine. Dans le cas de l'oxyde de zinc dopé à l'aluminium, le taux de dopage (c'est-à-dire le poids d'oxyde d'aluminium rapporté au poids total) est de préférence inférieur à 3%. Dans le cas du gallium, le taux de dopage peut être plus élevé, typiquement compris dans un domaine allant de 5 à 6%.

Dans le cas de l'ITO, le pourcentage atomique de Sn est de préférence compris dans un domaine allant de 5 à 70%, notamment de 10 à 60%. Pour les couches à base d'oxyde d'étain dopé au fluor, le pourcentage atomique de fluor est de préférence d'au plus 5%, généralement de 1 à 2%.

L'ITO est particulièrement préféré, notamment par rapport au SnO₂:F. De conductivité électrique plus élevée, son épaisseur peut être plus faible pour obtenir un même niveau d'émissivité. Aisément déposées par un procédé de pulvérisation cathodique, notamment assisté par champ magnétique, appelé « procédé magnétron », ces couches se distinguent par une plus faible rugosité, et donc un plus faible encrassement.

Un des avantages de l'oxyde d'étain dopé au fluor est en revanche sa facilité de dépôt par dépôt chimique en phase vapeur (CVD), qui contrairement au procédé de pulvérisation cathodique, ne nécessite pas de traitement thermique ultérieur, et peut être mis en oeuvre sur la ligne de production de verre plat par flottage.

Par « émissivité », on entend l'émissivité normale à 283 K au sens de la norme EN12898. L'épaisseur de la couche basse émissivité (TCO etc) est ajustée, en fonction de la nature de la couche, de manière à obtenir l'émissivité voulue, laquelle dépend des performances thermiques recherchées. L'émissivité de la couche basse émissivité est par exemple inférieure ou égale à 0,3, notamment à 0,25 ou même à 0,2. Pour des couches en ITO, l'épaisseur sera généralement d'au moins 40 nm, voire d'au moins 50 nm et même d'au moins 70 nm, et souvent d'au plus 150 nm ou d'au plus 200 nm. Pour des couches en oxyde d'étain dopé au fluor, l'épaisseur sera généralement d'au moins 120 nm, voire d'au moins 200 nm, et souvent d'au plus 500 nm.

Par exemple la couche basse émissivité comprend la séquence suivante :sous-couche haut indice/sous-couche bas indice/ une couche TCO/ surcouche diélectrique optionnelle.

Comme exemple préféré de couche basse émissivité (protégée durant une trempe, on peut choisir sous-couche haut indice (<40 nm) / sous-couche bas indice (<30 nm) / une couche ITO/ surcouche haut indice (5 - 15 nm))/ surcouche bas indice (<90 nm) barrière/ dernière couche (< 10 nm).

On peut citer comme couche basse émissivité celles décrites dans le brevet US2015/0146286, sur la face F4, notamment dans les exemples 1 à 3.

Dans une réalisation préférée :
- le premier et/ou le deuxième vitrage est teinté et/ou l'intercalaire de feuilletage est teinté sur tout en partie de son épaisseur (notamment en dehors du côté de la surface la plus lumineuse, souvent celle avec les altérations)
- et/ou l'une des faces F2 ou F3 ou F4 -de préférence la face F4 - du toit vitré, est revêtue d'une couche basse émissivité, notamment comprenant une couche d'oxyde transparent électro-conducteur (dite TCO) notamment un empilement de couches minces avec couche TCO ou un empilement de couches minces avec couche(s) d'argent
- et/ou l'une des faces F2 ou F3 ou F4 -de préférence la face F3 - du toit vitré, est revêtue d'une couche de contrôle solaire, notamment comprenant une couche d'oxyde transparent électro-conducteur (dite TCO) notamment un empilement de couches minces avec couche TCO ou un empilement de couches minces avec couche(s) d'argent
- et/ou un film additionnel (polymérique, comme un polyéthylène téraphtalate PET etc) teinté est entre les faces F2 et F3 ou (collé) en F4 voire en face F1.

En particulier, la face F4 du vitré, est revêtue d'une couche fonctionnelle transparente notamment basse émissivité, de préférence comprenant une couche TCO, dont une zone (alimentée électriquement, donc électrode) formant bouton tactile (pour piloter la première surface lumineuse).

L'invention concerne bien entendu tout véhicule notamment automobile comportant au moins un toit tel que décrit précédemment.

L'invention concerne enfin un procédé de fabrication du toit tel que décrit précédemment qui comporte les étapes suivantes:
- découpe par exemple automatique (robotisé) de l'intercalaire de feuilletage sous forme d'une unique feuille (de PVB de préférence et même acoustique, teinté ou non) ou d'un feuillet composite PVB/film plastique fonctionnel portant un éventuel revêtement fonctionnel ou PVB//film plastique fonctionnel portant un éventuel revêtement fonctionnel /PVB, feuille ou feuillet de préférence d'épaisseur d'au plus 0,9mm et même (si feuille PVB unique) d'épaisseur d'au plus 0,4mm pour former une ou des ouvertures de préférence traversantes et locales (géométrique : rondes, carrés, rectangulaires, notamment de la même forme que les diodes), de préférence autant (et pas plus) d'ouvertures locales (ou de trous borgnes locaux) que de diodes, ou une ouverture (locale) commune au groupe de diodes,
- ou plus précisément l'intercalaire de feuilletage (de PVB de préférence) comportant un premier feuillet (de PVB de préférence) unique ou un premier feuillet composite PVB/film plastique fonctionnel portant un éventuel revêtement fonctionnel ou PVB//film plastique fonctionnel portant un éventuel revêtement fonctionnel /PVB, premier feuillet de préférence d'épaisseur d'au plus 0,9mm et même (si feuillet PVB unique) d'épaisseur d'au plus 0,4mm, et un deuxième feuillet thermoplastique (de PVB de préférence) notamment d'épaisseur d'au plus 0,4mm et même d'épaisseur d'au plus 0,2mm, est entre la face arrière d'un support de diodes et la face F2 (ou F3 si diode(s) à montage inverse), découpe (automatique) du premier feuillet de préférence d'épaisseur d'au plus 0,9mm pour former une ou des ouvertures de préférence traversantes et locales (géométriques : rondes, carrés, rectangulaires, notamment de la même forme que les diodes), de préférence autant (et pas plus) d'ouvertures locales que de diodes, ou une ouverture commune au groupe de diodes,
- assemblage du vitrage feuilleté, avec la ou les diodes logées dans ladite ouverture débouchante ou borgne (notamment commune au groupe de diodes) ou lesdites ouvertures (locales) débouchantes ou borgnes (notamment individuelles, une ouverture par diode), et notamment avant le feuilletage, ouverture(s) plus grande(s) (large(s)) que la taille (largeur) de la ou des diodes de préférence plus grande(s) (large((s) d'au plus 1mm, mieux d'au plus 0,5mm ou même d'au plus 0,2mm ou d'au plus 0,1mm.

On réalise le feuilletage (mise sous pression, chauffage) qui peut influer sur la largeur de la ou les ouvertures, par fluage de l'intercalaire. Par fluage, l'intercalaire de feuilletage (premier feuillet, feuille ou feuillet composite) avec la ou les ouvertures plus larges que la ou des diodes, s'étend jusqu'à être en contact avec la tranche de la diode (de son enveloppe). Et éventuellement, pour chaque ouverture traversante l'intercalaire de feuilletage (premier feuillet, feuille ou feuillet composite) peut s'étendre jusqu'à être entre ladite surface avant de l'enveloppe de la diode et la face F3 sans être en contact avec la face émettrice de la puce.

Le placement des diodes sur la face avant du support de diodes éventuel peut être manuel ou robotisé (plus précis).

Le support de diode(s) avec les diodes peut être positionné par rapport au vitrage (côté face arrière du support) et contraindre la mise en place de l'intercalaire de feuilletage trouée avec de préférence une découpe de l'intercalaire de feuilletage avec excès sur le contour du vitrage (et découpe de l'excédent après mise en place du vitrage côté face avant), ou encore le support de diode(s) avec les diodes peut être positionné par rapport à l'intercalaire de feuilletage trouée et est contraint par la mise en place de ce dernier et avec de préférence avec une découpe de l'intercalaire de feuilletage à la forme exacte du vitrage feuilleté. En particulier, le ou les trous sont borgnes (et locaux) et sont réalisés dans l'un des PVB du feuillet composite PVB//film plastique fonctionnel portant le revêtement fonctionnel /PVB sans toucher ledit revêtement fonctionnel.

De préférence, la ou les diodes sont des composants montés en surface de préférence sur une face dite avant orientée côté face F3 (F2 si montage inverse) d'un support de diodes flexible, notamment un film plastique (flexible) de préférence transparent, avec la face avant mise contre la feuille ou le premier feuillet PVB avec la ou les ouvertures (traversantes ou borgnes), support de diodes dépassant de préférence de la tranche du vitrage feuilleté.

Et la face arrière peut être contre ou collée côté face F2 (F3 si montage inverse). En particulier un feuillet de préférence PVB (par exemple teinté et/ou acoustique) est entre la face arrière et la face F2 (F3 si montage inverse), notamment plus mince que la feuille ou le premier feuillet (PVB ou composite tel que déjà décrit) avec la ou les ouvertures traversantes ou borgnes.

La présente invention est à présent expliquée plus en détail en référence aux figures annexées dans lesquelles :

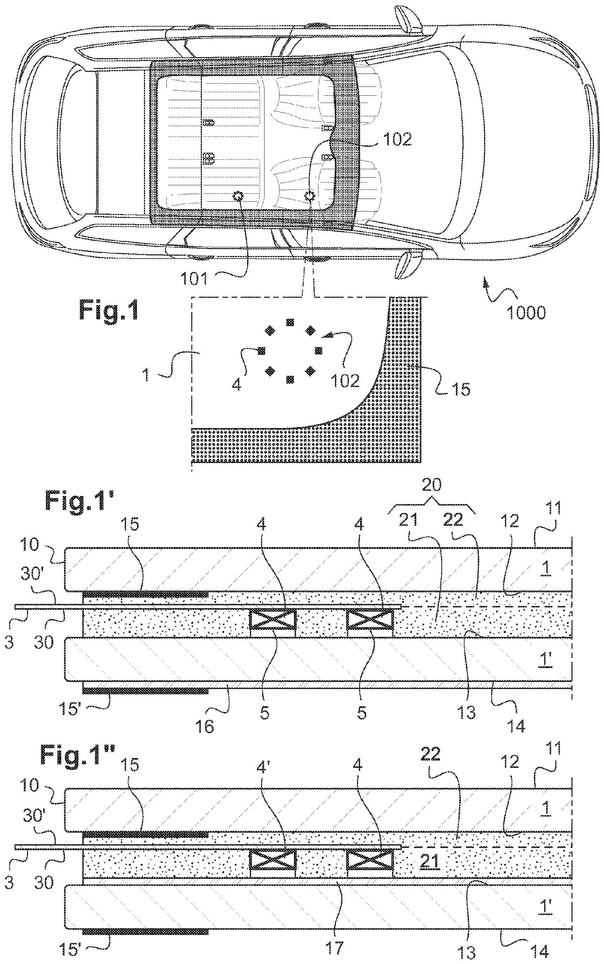

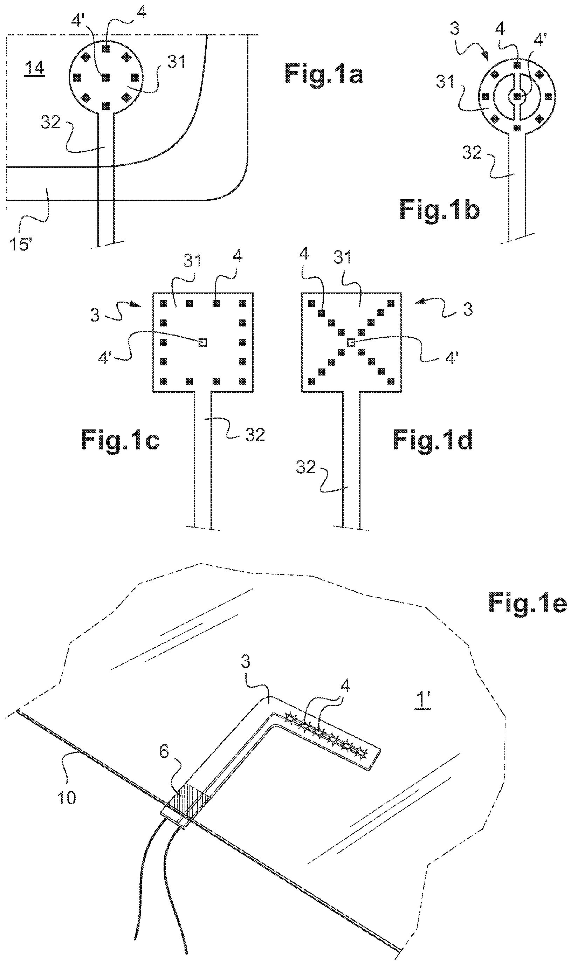

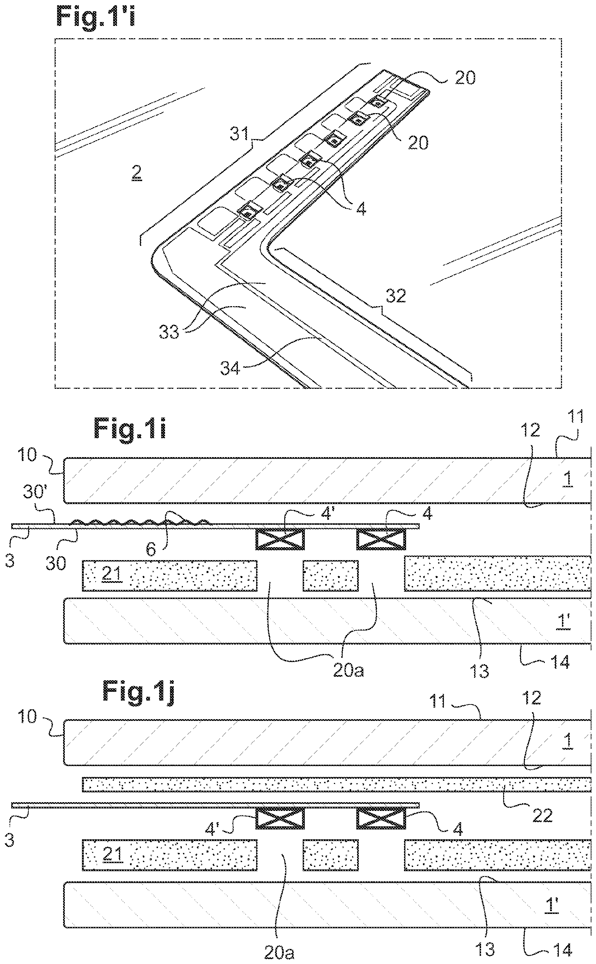

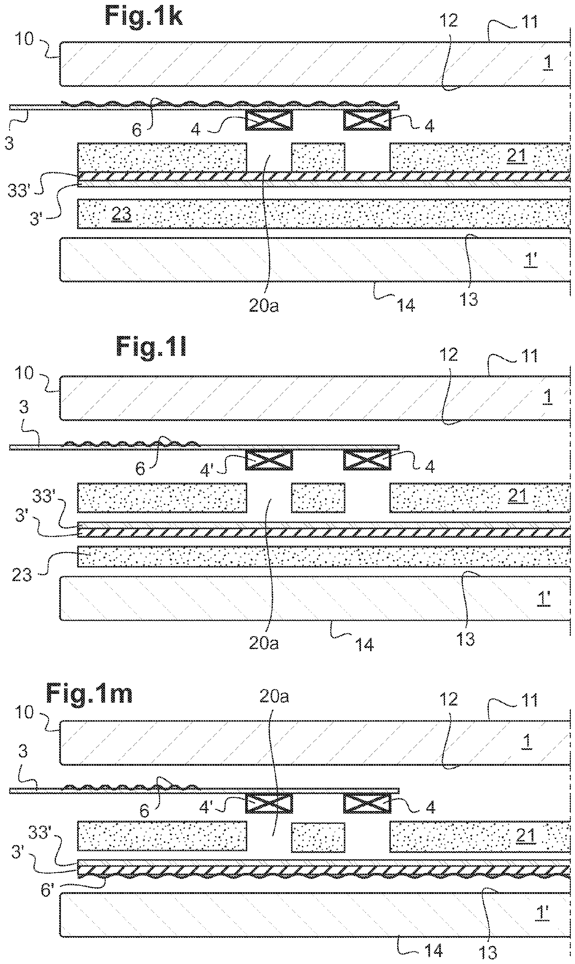

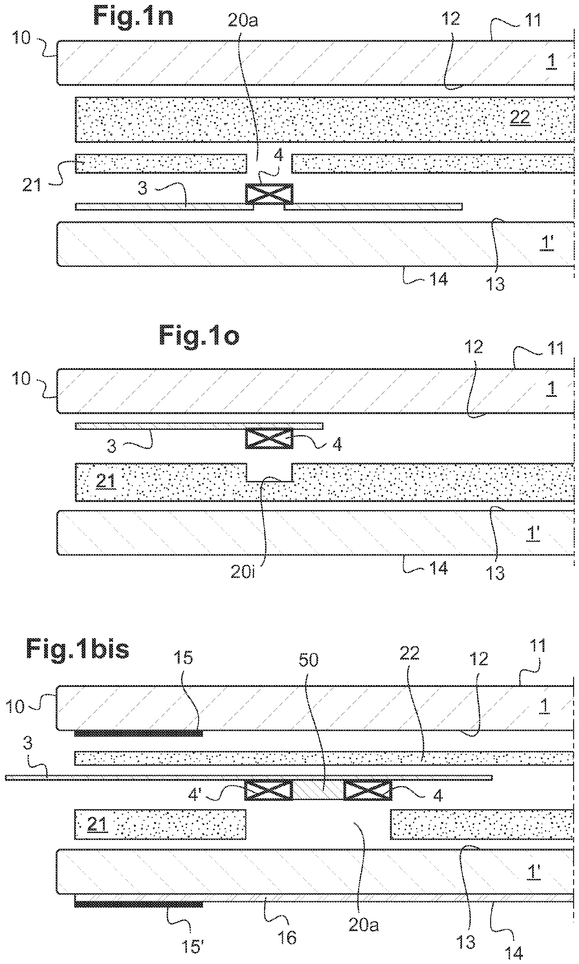

La figure 1 montre une vue de dessus d'un toit vitré feuilleté lumineux d'un véhicule automobile selon un premier mode de réalisation de l'invention et une vue de détail des diodes formant une liseuse.
La figure 1' montre une vue schématique partielle de coupe du toit vitré feuilleté lumineux dans une variante du premier mode de réalisation de l'invention.
La figure 1" montre une vue schématique partielle de coupe du toit vitré feuilleté lumineux dans une variante du premier mode de réalisation de l'invention.
Les figures 1a, 1b, 1c, 1d, 1e montrent des vues de face de supports à diodes côté face interne (orienté vers l'habitacle).
La figure 1'i montre une vue en perspective d'un PVB des ouvertures traversantes dans le cas de diodes en rangée.
Les figures 1i, 1j, 1k, 1l, 1m, 1n, 1o montrent des vues schématique partielle, en éclaté, de coupe du toit vitré feuilleté lumineux selon l'invention, illustrant des procédés de fabrication.
La figure 1bis montre une vue schématique partielle de coupe, en éclaté, du toit vitré feuilleté lumineux selon un mode de réalisation de l'invention.
La figure 2 montre une vue de détail schématique partielle de coupe, du toit vitré feuilleté lumineux selon un mode de réalisation de l'invention.

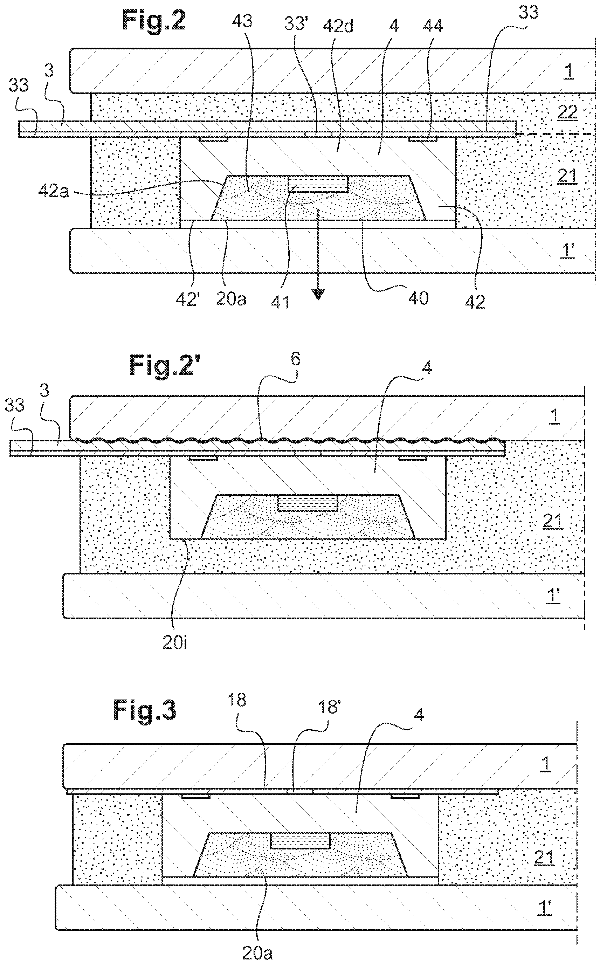

La figure 2' montre une vue de détail schématique partielle de coupe, du toit vitré feuilleté lumineux selon un mode de réalisation de l'invention.
La figure 3 montre une vue de détail schématique partielle de coupe, du toit vitré feuilleté lumineux selon un mode de réalisation de l'invention.

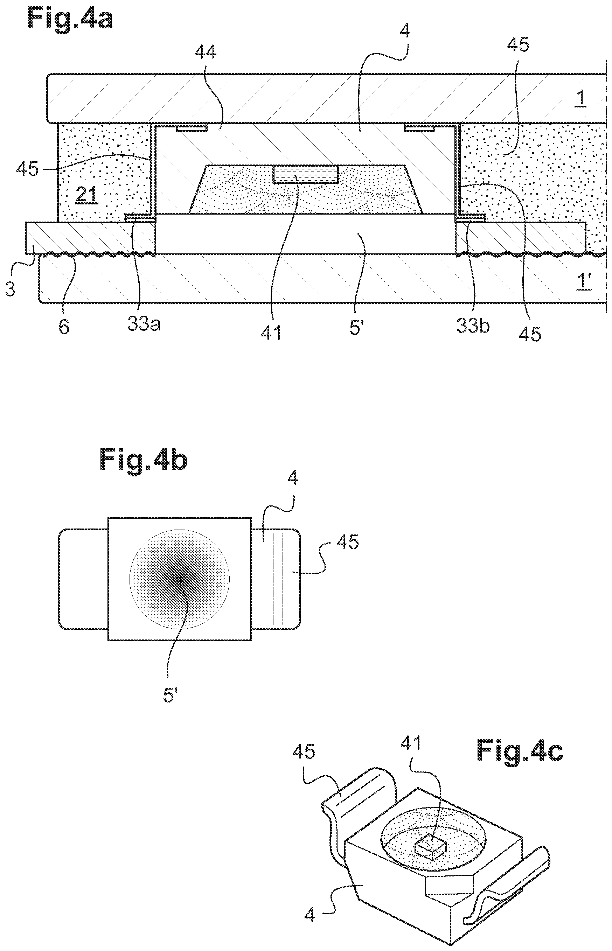

La figure 4a montre une vue de détail schématique partielle de coupe, du toit vitré feuilleté lumineux selon un mode de réalisation de l'invention et les figures 4b et 4c des exemples des diodes à montage inversé respectivement en vue de dessous ou en perspective.

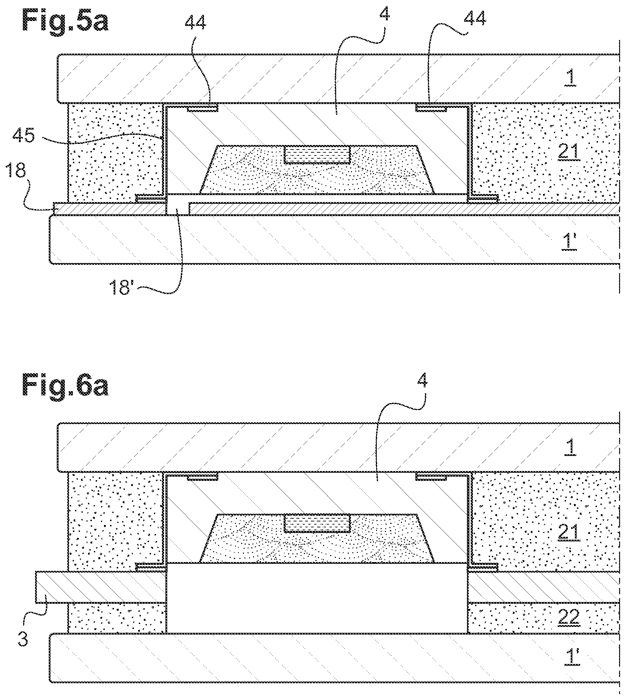

La figure 5a montre une vue de détail schématique partielle de coupe, du toit vitré feuilleté lumineux selon une variante du mode de réalisation de l'invention de la figure 4a.
La figure 6a montre une vue de détail schématique partielle de coupe, du toit vitré feuilleté lumineux selon un mode de réalisation de l'invention une variante du mode de réalisation de l'invention de la figure 4a.

La figure 1 montre une vue de dessus d'un toit vitré feuilleté lumineux d'un véhicule automobile 1000 selon un premier mode de réalisation de l'invention avec de deux ensembles de diodes 4 formant pour l'un une liseuse à l'arrière et pour l'autre à l'avant.

Un premier ensemble de huit diodes 4 (cf la vue de détail) est sur une première carte de circuit imprimé dite carte PCB (non représentée ici) intégrée entre les deux vitrages du vitrage feuilleté, huit diodes formant un rond disposées dans le clair de vitre dans une zone de bord longitudinal au voisinage d'une zone périphérique de masquage externe 15 (émail opaque...) sur le vitrage extérieur, ou en variante devant- et d'une zone de masquage interne (couche, émail opaque..) de taille similaire sur le vitrage intérieur (non visible)-.

Alternativement, la liseuse est masquée par la zone de masquage interne et une ou des épargnes sont faites dans la zone de masquage interne ou même est dans une zone (de transition) avec une alternance zone de masquage (couche opaque, comme un émail opaque) et zone transparente du vitrage intérieur.

La figure 1' montre une vue schématique partielle de coupe du toit vitré feuilleté lumineux dans une variante du premier mode de réalisation de l'invention. Le toit vitré feuilleté, bombé, comportant :
- un premier vitrage 1, par exemple en verre VG10 et de 2,1mm d'épaisseur, formant vitrage extérieur, avec des première et deuxième faces principales 11, 12 respectivement dites face F1 et face F2
- un deuxième vitrage 1', formant vitrage intérieur par exemple en verre TSA (ou clair ou extraclair) et de 2,1mm d'épaisseur ou même de 1,6mm ou encore de moins de 1,1mm (verre trempé chimiquement notamment), avec des troisième et quatrième faces principales 13, 14 respectivement dites face F3 et face F4,
- entre la face F2 et la face F3 formant les faces internes 12, 13 du vitrage feuilleté un intercalaire de feuilletage 20,21,22 en matière polymérique, ici en PVB, d'épaisseur Eₜ submillimétrique de préférence d'environ 1mm ou moins, comportant une couche (un feuillet) de PVB 21 avec une face FB en contact adhésif avec la face F3 (nue ou revêtue) et un ensemble d'ouvertures traversantes 5 (ici deux visibles) entre une face FA contre un support de diodes 3 et la face FB, l'épaisseur E entre ces faces FA et FB correspond à la hauteur des ouvertures H par exemple de 0,76mm environ pour un PVB classique (RC41 de Solutia ou d'Eastman) en variante si nécessaire un PVB acoustique (tricouche ou quadricouche) par exemple d'épaisseur 0,81mm environ
- une couche fonctionnelle 16 par exemple de basse émissivité en face F4 (ITO etc) et/ou alternativement la face F3 éventuellement revêtue d'une couche fonctionnelle (chauffante, basse émissivité etc).

Des diodes électroluminescentes inorganiques 4 sont des composants montés en surface (CMS ou SMD en anglais), sur le support de diodes, par exemple émettant dans le blanc.

Le support de diodes 3 est une carte à circuit imprimé dite carte PCB 3 d'épaisseur e'2 d'au plus 0,2mm et de préférence de 0,1mm à 0,2mm. Le support de diodes 3 dépasse de la tranche du vitrage feuilleté. Par exemple il comporte une partie porteuse des diodes et une partie pour la connectique dépassant du vitrage et (en partie) entre les couches périphériques de masquages interne et externe 15',15. La couche 15' peut être en partie sur la couche fonctionnelle 16.

La face dite avant 30 du support de diodes 3 est porteuse de pistes conductrices en regard de la face F3 et la face arrière 30' est du côté de la face F2 ou face 12 contre un PVB arrière 22 en contact adhésif avec la face F2 (nue ou revêtue), PVB plus mince par exemple. Chaque diode 4 a une face émettrice émettant en direction du vitrage intérieur 1', et chaque diode ayant une tranche.

Pour chacune des diodes, l'intercalaire de feuilletage 21 comprend donc une ouverture traversante 20a entourant la tranche de la diode 4 et même en contact de sa tranche ou en variante espacé d'au plus 0,5mm et même d'au plus 0,1mm de la tranche.

Les diodes 4 (avec une seule puce semi-conductrice ici) sont de forme carrée de largeur de l'ordre de 5mm ou moins. Les diodes sont d'épaisseur e2 inférieure à la hauteur du trou H. Les diodes ne sont pas en surépaisseur au risque de fragiliser le verre en créant des points de contraintes. Et les diodes de préférence ne doivent être trop espacées de la face F3 au risque de créer trop de bulles d'air.

On choisit une carte PCB 3 la plus fine possible, par exemple de 0,1mm, flexible et dans le cas montré ici ou les diodes 4 sont dans le clair de vitre (hors de la périphérie avec les couches de masquages externe et interne 15 et 15') même de préférence la plus discrète possible (largeur minimale ou même transparence) par exemple comportant un film transparent comme un PET, PEN ou un polyimide et même pour le circuit imprimé des pistes de connexion transparentes (plutôt qu'en cuivre ou autre métal sauf à les faire suffisamment fines).

Lors de la fabrication on choisit par exemple un premier feuillet 21, en PVB, avec les ouvertures traversantes (ou borgnes en variante) et un deuxième feuillet de PVB 22 côté face arrière 30' de la carte PCB 3. Par fluage les deux feuillets sont accolés avec ou non une interface discernable (ici en pointillés).

La couche 16 peut avoir une zone formant interrupteur tactile pour allumer la liseuse.

La figure 1" montre une vue schématique partielle de coupe du toit vitré feuilleté dans une variante de la figure 1' dans laquelle :
- une couche fonctionnelle 17 par exemple une couche chauffante est en face F3.
- la couche en face F4 est supprimée (éventuellement).

La couche 17 a une zone formant interrupteur tactile pour allumer la liseuse. On ajoute sur le support 3 une diode 4' formant témoin lumineux de la zone d'interrupteur tactile (dans son ouverture traversante associée).

Les figures 1a, 1b, 1c, 1d, 1e montrent des vues de face de supports à diodes côté face interne (orienté vers l'habitacle) avec des arrangements différents de diodes.

La carte PCB 3 comporte une première partie 31 porteuse des diodes, et une partie 32 moins large d'alimentation électrique débouchant au-delà de la tranche du toit. Plus précisément :
- en figure 1a on utilise neuf diodes dont huit diodes 4 en rond formant liseuse et une centrale 4' formant témoin lumineux
- en figure 1b on utilise neuf diodes dont huit diodes 4 en rond formant liseuse et une centrale 4' formant témoin lumineux et on évide une partie 31 du support porteuse des diodes pour plus de discrétion
- en figure 1c on utilise quinze diodes dont quatorze diodes 4 en carré formant liseuse et une centrale 4' formant témoin lumineux
- en figure 1d on utilise dix-sept diodes dont seize diodes 4 en croix formant liseuse et une centrale 4' formant témoin lumineux
- en figure 1e on utilise une rangée de six diodes 4 et par exemple le support 3 est coudé, en L avec un adhésif 6 d'étanchéité si contre la face F2, la partie de connectique 32 dépassant de la tranche 10.

Les figures 1i,1j,1k,1l,1m,1n,1o montrent des vues schématiques partielles, en éclaté, de coupe du toit vitré feuilleté lumineux selon l'invention, illustrant des procédés de fabrication impliquant un support de diodes 3, de préférence transparent, flexible et mince (moins de 0,2mm) avec une face avant 30 contre une face d'un feuillet PVB avec les ouvertures traversantes 20a (ou les trous borgnes) et une face arrière 30' vers la face F2. Le support 3 s'étend au-delà de la tranche 10 du vitrage feuilleté.

En figure 1i, on utilise un seul feuillet PVB 21 avec les ouvertures traversantes ou en variante les trous borgnes, feuillet qui peut être classique et/ou acoustique et/ou teinté.

En figure 1j, on utilise :
- un premier feuillet PVB 21 avec les ouvertures traversantes ou en variante les trous borgnes, feuillet qui peut être classique et/ou acoustique et/ou teinté, de préférence ouvertures locales plus larges que les diodes 4, 4' avant feuilletage
- et un deuxième feuillet PVB 22 côté face arrière du support 3, feuillet qui peut être classique par exemple teinté et plus mince que le premier feuillet 21 (lui tenant compte de l'épaisseur des diodes).

En figure 1k, on utilise :
- un premier feuillet PVB 21 avec les ouvertures traversantes (ou borgnes ou variante), feuillet qui peut être classique et/ou acoustique et/ou teinté,
- un film transparent 3' de préférence flexible (PET etc), par exemple de 10 à 100µm porteur d'une couche fonctionnelle 33' côté face F2 (ou face F3 en variante) par exemple basse émissivité ou contrôle solaire, ici par exemple préassemblé avec le feuillet 21 et/ou alternativement avec un autre feuillet PVB 23 (plus mince que le premier feuillet par exemple) côté face F3, film 3' couvrant essentiellement les faces F2 et F3.

Le film transparent est par exemple préassemblé avec le premier feuillet 21 et l'autre feuillet 23 avant de réaliser les ouvertures traversantes ou de préférence borgnes dans l'épaisseur du PVB 21 plutôt que dans l'épaisseur PVB 21/film PET conducteur voire PVB 23.

On préfère que la couche 33' soit pleine donc distante (pas percée, ni touchée par les trous) des trous borgnes alors dans le PVB 21. La couche 33' peut être côté face F3 ou F2.

En figure 1l ou 1m, on utilise :
- un premier feuillet PVB 21 avec les ouvertures traversantes, feuillet qui peut être classique et/ou acoustique et/ou teinté.
- localement, en périphérie, un film transparent 3 (PET etc) porteur d'une couche fonctionnelle côté face F3 (ou face F2 en variante), par exemple formant un interrupteur tactile capacitif (pour allumer les diodes 4 formant liseuse),
- un autre feuillet PVB 23 (plus mince que le premier feuillet, figure 1l) côté face F3 ou alternativement un adhésif 6' collant le film 3 (figure 1m).

En figure 1n on utilise :
- un premier feuillet PVB 21 avec les ouvertures traversantes, feuillet qui peut être classique et/ou acoustique et/ou teinté
- et un deuxième feuillet PVB 22 côté face F2, feuillet qui peut être classique par exemple teinté et éventuellement plus mince que le premier feuillet (lui tenant compte de l'épaisseur des diodes)
- les diodes 4 sont à montage inversé c'est-à-dire la lumière passe dans le support 3 (percé si nécessaire) collé ou contre la face F3.

En figure 1o on utilise un premier feuillet PVB 21 avec les ouvertures formant trous borgnes 20i, feuillet qui peut être classique et/ou acoustique ;.

La figure 1bis montre une vue schématique partielle de coupe, en éclaté, du toit vitré feuilleté selon un mode de réalisation de l'invention

II diffère de celui montré en figure 1' par le fait que l'ouverture traversante 20a du PVB 21 est commune à des diodes et un espaceur 50 est entre les diodes 4. En variante, l'ouverture commune est borgne.

La figure 2 montre une vue de détail schématique partielle de coupe du toit vitré feuilleté 200' selon un mode de réalisation de l'invention.

Chaque diode, de préférence de puissance pour la liseuse, est un composant électronique incluant la puce semi-conductrice 41, et est équipée d'une enveloppe périphérique 42 (souvent dénommée « packaging »), polymérique ou céramique, encapsulant la tranche du composant électronique

L'intercalaire de feuilletage (par fluage lors du feuilletage) peut s'étendre jusqu'à être entre la surface dite avant 42' de l'enveloppe et la face F3 sans aller jusqu'à la face avant 40 de la diode (face émettrice de la puce ou plus précisément face de l'ensemble puce et matière couvrante de protection ou à fonction de conversion de longer d'onde 43 (luminophore). L'enveloppe peut avoir un profil évasé 42a en s'éloignant de la puce 41.

Le composant électronique 4 comporte ainsi généralement une embase 42b ici partie dite inférieure de l'enveloppe porteuse de la puce-semi-conductrice et un réflecteur évasé vers face F3, ici une partie supérieure 42a de l'enveloppe.

La matière 43 peut être une résine transparente et/ou mélange à un luminophore.

Le luminophore peut être juste sur la puce 41. La matière 43 peut être sous affleurante de la surface (du réflecteur) 42a, notamment créant une lame d'air qui peut être utile.

Des exemples de diodes sont décrits dans le document « les leds pour l'éclairage de Laurent Massol » Edition dunod en pages 140; 141.

L'intercalaire de feuilletage peut s'étendre jusqu'à être entre ladite surface avant 42' de l'enveloppe et la face F3 sans être en contact avec la face émettrice de la puce ou la surface 40.

L'enveloppe est par exemple en époxy ou en céramique. Une enveloppe polymérique peut éventuellement se tasser (l'épaisseur finale après feuilletage peut être inférieure à l'épaisseur initiale) lors du feuilletage. L'enveloppe (polymérique) peut être opaque.

En face arrière de la diode (de l'enveloppe), il y a deux surfaces de contacts électriques 44 sur des zones 33 (isolées par gravure 33' etc) d'une couche électroconductrice 33 sur le support 3.

La figure 2' montre une vue de détail schématique partielle de coupe, du toit vitré feuilleté selon un mode de réalisation de l'invention qui diffère de la figure 2 par le fait que le feuillet PVB 22 arrière (contre face F2) est supprimé et remplacé par une colle 6.

La figure 3 montre une vue de détail schématique partielle de coupe, du toit vitré feuilleté selon un mode de réalisation de l'invention qui diffère de la figure 2 par le fait que le feuillet PVB arrière (contre face F2) est supprimé et même le support de diodes car les connexions (électriques) sont sur la face F2 sous forme d'une couche électroconductrice notamment transparente 18 (zones électroconductrices isolées par une isolation 18' par exemple une bande isolante 18' de largeur submillimétrique, faite par gravure laser par exemple). En variante, l'ouverture est borgne.

La figure 4a montre une vue de détail schématique partielle de coupe, du toit vitré feuilleté selon un mode de réalisation de l'invention qui diffère de la figure 1e en ce que les diodes 4 sont à montage inversé donc avec un support de diodes 3 côté face F3 (collé via un adhésif 6 à la face F3) et les contacts 44 sont reliées par des contacts latéraux 45 comme des ailettes métalliques aux pistes de connexion 33a, 33b côté face arrière (vers F2) du support. Le support 3 peut être percé, avec un trou traversant, 5' pour laisser (mieux) passer la lumière.

Les figures 4b et 4c sont des exemples des diodes 4 à montage inversé respectivement en vue de dessous ou en perspective.

La figure 5a montre une vue de détail schématique partielle de coupe du toit vitré feuilleté selon une variante du mode de réalisation de l'invention de la figure 4a dans lequel le support de diodes est supprimé et les contacts 44 sont reliées par des contacts latéraux 45 comme des ailettes métalliques aux pistes de connexion 18 avec isolation 18' sur la face F3 par exemple une couche électroconductrice 18 (transparente) en au moins deux zones isolées par une bande isolante 18'. Il peut s'agir d'une couche électroconductrice couvrant la face F3 et ayant une fonction en outre de couche de contrôle solaire et/ou chauffante.

La figure 6a montre une vue de détail schématique partielle de coupe du toit vitré feuilleté selon une variante du mode de réalisation de l'invention de la figure 4a dans lequel la face avant du support 3 est feuilleté à la face F3 par un feuillet PVB 22 qui présente également une ouverture traversante de préférence.

## Revendications

1. Toit vitré feuilleté lumineux de véhicule notamment automobile (1000) comprenant :
- un vitrage feuilleté comportant :
- un premier vitrage transparent (1), en verre minéral, éventuellement teinté, avec des faces principales (11, 12) dite faces F1 et F2; vitrage destiné à être le vitrage extérieur,
- un deuxième vitrage transparent (1') en verre minéral, éventuellement teinté avec des faces principales (13, 14) dites faces F3 et F4, vitrage destiné à être le vitrage intérieur
- entre les faces F2 et F3 qui sont les faces internes du vitrage feuilleté, un film intercalaire de feuilletage transparent, éventuellement teinté, en matière polymérique thermoplastique (2, 20), film intercalaire de feuilletage ayant une face principale FA côté face F2 et une face principale FB côté face F3,
- un ensemble de N>1 diodes électroluminescentes inorganiques (4), chaque diode comportant au moins une puce semi-conductrice (41), chaque diode étant apte à émettre en direction de la face F3,
**caractérisé en ce que** ledit intercalaire de feuilletage est pourvu entre la face FA et la face FB d'un ensemble de M>1 ouvertures qui sont traversantes (20a) ou formant trous borgnes (20i), chaque diode étant d'épaisseur e2 étant submillimétrique et étant logée dans une ouverture traversante ou un trou borgne,
**en ce que** chaque diode étant associée à une ouverture traversante ou un trou borgne entourant la tranche de la diode
et **en ce qu'**un support de diodes (3), flexible, est collé ou plaqué contre la face F2 ou la face F3 en montage inversé des diodes, ledit support de diodes étant d'épaisseur e'2 submillimétrique d'au plus 0,2mm.

2. Toit vitré feuilleté lumineux de véhicule selon la revendication précédente **caractérisé en ce que** chaque diode étant un composant électronique (40) équipée d'une enveloppe périphérique (42), notamment polymérique ou céramique, encapsulant la tranche du composant électronique, notamment enveloppe définissant la tranche de la diode, en saillie et en entourant la puce semi-conductrice.

3. Toit vitré feuilleté lumineux lumineuse de véhicule selon l'une quelconque des revendications précédentes **caractérisé en ce que** le support de diodes (3), est d'épaisseur e'2 de préférence d'au plus 0,1mm et **en ce que** le support de diodes dépasse de la tranche du vitrage feuilleté, notamment comporte une première partie 31 porteuse des diodes, et une partie (32) moins large d'alimentation électrique débouchant au-delà de la tranche du vitrage feuilleté.

4. Toit vitré feuilleté lumineux de véhicule selon l'une des revendications précédentes **caractérisé en ce que** le support de diodes (3) comporte une première partie (31) porteuse des diodes qui est évidée.

5. Toit vitré feuilleté lumineux de véhicule selon l'une des revendications 3 à 4 **caractérisé en ce qu'**il comprend un feuillet en matière thermoplastique, de préférence PVB, entre la face arrière du support de diodes et la face F2 ou la face F3 en montage inversé des diodes, de préférence feuillet d'épaisseur d'au plus 0,4mm.

6. Toit vitré feuilleté lumineux de véhicule selon l'une des revendications précédentes **caractérisé en ce que** l'ouverture traversante ou le trou borgne est dans une épaisseur de PVB.

7. Toit vitré feuilleté lumineux de véhicule selon l'une des revendications précédentes **caractérisé en ce que** l'ouverture traversante ou le trou borgne est dans une épaisseur d'un intercalaire de feuilletage acoustique notamment PVB acoustique et/ou teinté notamment PVB teinté.

8. Toit vitré feuilleté lumineux de véhicule selon l'une des revendications précédentes **caractérisé en ce que** l'ouverture traversante ou le trou borgne est dans un matériau composite : PVB/film plastique transparent ou encore PVB/film plastique transparent/PVB, ledit film plastique, notamment un PET, d'épaisseur submillimétrique notamment d'au plus 0,15mm ou même d'au plus 0,05mm étant de préférence porteur d'un revêtement fonctionnel, notamment transparent, basse émissivité ou de contrôle solaire et/ou encore chauffant en particulier une couche électroconductrice notamment transparente, en particulier le revêtement fonctionnel est plein et même le film plastique est plein, notamment le film plastique est entre le revêtement fonctionnel et le trou borgne.

9. Toit vitré feuilleté lumineux de véhicule selon l'une quelconque des revendications précédentes **caractérisé en ce que** le support de diodes (3) comporte un film transparent en matière plastique, de préférence en poly(éthylène téréphtalate) ou en polyimide, le circuit électrique est pourvu de pistes conductrices de préférence transparentes, la face avant du support de diodes étant notamment contre l'intercalaire de feuilletage avec les ouvertures traversantes ou borgnes, notamment contre la face FA ou contre la face FB en montage inversé des diodes.

10. Toit vitré feuilleté lumineux de véhicule selon l'une des revendications précédentes **caractérisé en ce que** le support de diodes (3) s'étend au moins jusqu'à la tranche (10) du vitrage feuilleté et de préférence dépasse de la tranche, notamment la partie de connectique, et entre la face arrière (30') du support de diodes et la face F2 ou la face F3 en montage inversé des diodes, est logé un adhésif étanche à l'eau liquide (6) d'épaisseur d'au plus 0,1mm et mieux d'au plus 0,05mm, notamment un adhésif double face.

11. Toit vitré feuilleté lumineux de véhicule selon l'une des revendications précédentes **caractérisé en ce que** le support de diodes (3) couvre essentiellement les faces F2 et F3 et de préférence est porteur d'un revêtement fonctionnel, notamment transparent, basse émissivité ou de contrôle solaire et/ou encore chauffant, et est d'épaisseur e'2 de préférence qui est d'au plus 0,15mm et même d'au plus 0,1mm et de préférence le support de diodes dépasse de la tranche du vitrage feuilleté, notamment la partie de connectique.

12. Toit vitré feuilleté lumineux de véhicule selon l'une des revendications précédentes **caractérisé en ce que** des diodes dudit ensemble forme une liseuse et sont de préférence dans des ouvertures traversantes et/ou sur le support de diodes entre la face F2 et la face FA.

13. Toit vitré feuilleté lumineux de véhicule selon l'une des revendications précédentes **caractérisé en ce que** la diode forme un indicateur lumineux d'un interrupteur tactile déporté côté face F3 et en regard de la diode formant indicateur lumineux, la diode forme ledit indicateur lumineux est de préférence sur le support de diodes comportant des diodes dudit ensemble entre la face F2 et la face FA.

14. Véhicule comportant au moins un toit vitré feuilleté lumineux selon l'une quelconque des revendications précédentes.

15. Procédé de fabrication du toit vitré feuilleté lumineux selon l'une des revendications précédentes de toit **caractérisé en ce qu'**il comporte les étapes suivantes:
- découpe d'une unique feuille de PVB notamment acoustique et/ou teintée ou d'un feuillet composite PVB/film plastique fonctionnel portant un éventuel revêtement fonctionnel ou PVB//film plastique fonctionnel portant un éventuel revêtement fonctionnel/PVB, feuille ou feuillet d'épaisseur de préférence d'au plus 0,9mm, pour former une ou des ouvertures locales traversantes ou borgnes, autant d'ouvertures locales que de diodes,
- assemblage du vitrage feuilleté, avec les diodes logées dans les ouvertures plus larges que la taille des diodes avant le feuilletage.

16. Procédé de fabrication du toit vitré feuilleté lumineux selon la revendication précédente **caractérisé en ce que** les ouvertures sont borgnes, chaque ouverture est réalisée dans l'un des PVB du feuillet composite PVB/film plastique fonctionnel portant le revêtement fonctionnel /PVB sans toucher ledit revêtement fonctionnel voire même le film plastique fonctionnel.

17. Procédé de fabrication du toit vitré feuilleté lumineux selon l'une des revendications 15 à 16 **caractérisé en ce que** les diodes (4) sont des composants montés en surface de préférence sur une face dite avant orientée côté face F3 du support de diodes flexible (3) ou côté face F2 si diode(s) à montage inverse, notamment un film plastique de préférence transparent, avec la face avant mise contre le PVB de la feuille ou du feuillet composite avec les ouvertures traversantes ou borgnes, support de diodes qui dépasse de préférence de la tranche du vitrage feuilleté, notamment la partie de connectique.

18. Procédé de fabrication du toit vitré feuilleté lumineux selon la revendication précédente **caractérisé en ce que** la feuille ou le feuillet composite est un premier feuillet et un deuxième feuillet thermoplastique de préférence PVB est entre la face arrière du support de diodes et la face F2 ou la face F3 si diode(s) à montage inverse.

19. Procédé de fabrication du toit vitré feuilleté lumineux selon la revendication précédente **caractérisé en ce que** l'intercalaire de feuilletage avec les ouvertures plus larges que les diodes s'étend par fluage jusqu'à être en contact avec la tranche des diodes et **en ce qu'**éventuellement, pour chaque ouverture traversante s'étend jusqu'à être entre ladite surface avant de l'enveloppe de la diode et la face F3 sans être en contact avec la face émettrice de la puce.

## Patentansprüche

1. Beleuchtetes Verbundglasschiebedach eines Fahrzeugs, insbesondere Kraftfahrzeugs (1000), umfassend:
- eine Verbundverglasung, die aufweist:
- eine erste transparente Verglasung (1) aus, optional getöntem, Mineralglas mit als Flächen F1 und F2 bezeichneten Hauptflächen (11,12); wobei die Verglasung als die äußere Verglasung vorgesehen ist,
- eine zweite transparente Verglasung (1') aus, optional getöntem, Mineralglas mit als Flächen F3 und F4 bezeichneten Hauptflächen (13, 14), wobei die Verglasung als die innere Verglasung vorgesehen ist
- zwischen den Flächen F2 und F3, welche die Innenflächen der Verbundverglasung sind, eine, optional getönte, transparente Verbundzwischenfolie, aus thermoplastischem Polymermaterial (2, 20), wobei die Verbundzwischenfolie bezüglich der Fläche F2 eine Hauptfläche FA und bezüglich der Fläche F3 eine Hauptfläche FB vorweist,
- eine Anordnung von N>1 anorganischen Leuchtdioden (4), wobei jede Diode mindestens einen Halbleiterchip (41) aufweist, wobei jede Diode geeignet ist, in die Richtung der Fläche F3 zu emittieren,
**dadurch gekennzeichnet, dass** die Verbundzwischenlage zwischen der Fläche FA und der Fläche FB mit einer Anordnung von M>1 Öffnungen, die Durchgangsöffnungen (20a) sind oder Sacklöcher (20i) bilden, versehen ist, wobei jede Diode eine Dicke e2 im Submillimeterbereich aufweist und in einer Durchgangsöffnung oder einem Sackloch aufgenommen ist,
dass jede Diode einer Durchgangsöffnung oder einem Sackloch zugeordnet ist, die oder das den Rand der Diode umgibt,
und dass ein biegsamer Diodenträger (3) an der Fläche F2 oder, bei entgegengesetzter Anbringung der Dioden, an der Fläche F3 angeklebt oder angedrückt ist, wobei der Diodenträger eine Submillimeterdicke e'2 von höchstens 0,2 mm aufweist.

2. Beleuchtetes Verbundglasschiebedach eines Fahrzeugs nach dem vorstehenden Anspruch, **dadurch gekennzeichnet, dass** jede Diode eine elektronische Komponente (40) ist, die mit einer umlaufenden Hülle (42), insbesondere aus Polymer oder Keramik, ausgestattet ist, die den Rand der elektrischen Komponente, wobei die Hülle insbesondere den Rand der Diode definiert, durch Überstehen und Umgeben des Halbleiterchips einkapselt.

3. Beleuchtetes Verbundglasschiebedach eines Fahrzeugs nach einem der vorstehenden Ansprüche, **dadurch gekennzeichnet, dass** der Diodenträger (3) eine Dicke e'2 von vorzugsweise höchstens 0,1 mm aufweist, und dass der Diodenträger über den Rand der Verbundverglasung hinaus ragt, insbesondere einen ersten, Dioden tragenden Abschnitt 31 und einen weniger breiten Abschnitt (32) zur Stromversorgung, der außerhalb des Rands der Verbundverglasung mündet, aufweist.

4. Beleuchtetes Verbundglasschiebedach eines Fahrzeugs nach einem der vorstehenden Ansprüche, **dadurch gekennzeichnet, dass** der Diodenträger (3) einen ersten Dioden tragenden Abschnitt (31), der ausgespart ist, aufweist.

5. Beleuchtetes Verbundglasschiebedach eines Fahrzeugs nach einem der Ansprüche 3 bis 4, **dadurch gekennzeichnet, dass** es zwischen der rückseitigen Fläche des Diodenträgers und der Fläche F2 oder, bei entgegengesetzter Anbringung der Dioden, der Fläche F3 eine Folie aus thermoplastischem Material, vorzugsweise PVB, umfasst, vorzugsweise eine Folie mit einer Dicke von höchstens 0,4 mm.

6. Beleuchtetes Verbundglasschiebedach eines Fahrzeugs nach einem der vorstehenden Ansprüche, **dadurch gekennzeichnet, dass** sich die Durchgangsöffnung oder das Sackloch in einer Dicke aus PVB befindet.

7. Beleuchtetes Verbundglasschiebedach eines Fahrzeugs nach einem der vorstehenden Ansprüche, **dadurch gekennzeichnet, dass** sich die Durchgangsöffnung oder das Sackloch in einer Dicke einer akustischen Verbundzwischenlage, insbesondere akustisches und/oder getöntes PVB, insbesondere getöntes PVB, befindet.

8. Beleuchtetes Verbundglasschiebedach eines Fahrzeugs nach einem der vorstehenden Ansprüche, **dadurch gekennzeichnet, dass** sich die Durchgangsöffnung oder das Sackloch in einem Verbundwerkstoff: PVB/transparente Kunststofffolie oder auch PVB/transparente Kunststofffolie/PVB befindet, wobei die Kunststofffolie, insbesondere ein PET, mit einer Dicke im Submillimeterbereich insbesondere von höchstens 0,15 mm oder sogar höchstens 0,05 mm, vorzugsweise eine funktionelle, insbesondere transparente, Beschichtung trägt mit niedrigem Emissionsgrad oder mit Solarsteuerung und/oder außerdem Heizmitteln insbesondere einer elektrisch leitenden, insbesondere transparenten, Schicht trägt, wobei insbesondere die funktionelle Beschichtung massiv ist und sogar die Kunststofffolie massiv ist, wobei sich insbesondere die Kunststofffolie zwischen der funktionellen Beschichtung und dem Sackloch befindet.

9. Beleuchtetes Verbundglasschiebedach eines Fahrzeugs nach einem der vorstehenden Ansprüche, **dadurch gekennzeichnet, dass** der Diodenträger (3) eine transparente Folie aus Kunststoff, vorzugsweise aus Poly(ethylenterephthalat) oder aus Polyimid, aufweist, wobei der elektrische Schaltkreis mit vorzugsweise transparenten Leiterbahnen versehen ist, wobei die Vorderfläche des Diodenträgers insbesondere an der Verbundzwischenlage mit den Durchgangsöffnungen oder Sacklöchern, insbesondere an der Fläche FA oder, bei entgegengesetzter Anbringung der Dioden, an der Fläche FB anliegt.

10. Beleuchtetes Verbundglasschiebedach eines Fahrzeugs nach einem der vorstehenden Ansprüche, **dadurch gekennzeichnet, dass** sich der Diodenträger (3) mindestens bis zum Rand (10) der Verbundverglasung erstreckt und vorzugsweise über den Rand, insbesondere den Anschlussabschnitt, hinausragt und wobei zwischen der rückseitigen Fläche (30') des Diodenträgers und der Fläche F2 oder, bei entgegengesetzter Anbringung der Dioden, der Fläche F3 ein flüssiger wasserfester Klebstoff (6) mit einer Dicke von höchstens 0,1 mm und besser höchstens 0,05 mm, insbesondere ein doppelseitiges Klebeband, aufgenommen ist.

11. Beleuchtetes Verbundglasschiebedach eines Fahrzeugs nach einem der vorstehenden Ansprüche, **dadurch gekennzeichnet, dass** der Diodenträger (3) die Flächen F2 und F3 im Wesentlichen bedeckt und vorzugsweise eine, funktionelle, insbesondere transparente, Beschichtung mit niedrigem Emissionsgrad oder mit Solarsteuerung und/oder außerdem Heizmitteln trägt und vorzugsweise eine Dicke e'2 von höchstens 0,15 mm und sogar höchstens 0,1 mm aufweist und wobei vorzugsweise der Diodenträger über den Rand der Verbundverglasung, insbesondere den Anschlussabschnitt, hinausragt.

12. Beleuchtetes Verbundglasschiebedach eines Fahrzeugs nach einem der vorstehenden Ansprüche, **dadurch gekennzeichnet, dass** die Dioden der Anordnung eine Leseleuchte bilden und sich vorzugsweise in Durchgangsöffnungen und/oder auf dem Diodenträger zwischen der Fläche F2 und der Fläche FA befinden.

13. Beleuchtetes Verbundglasschiebedach eines Fahrzeugs nach einem der vorstehenden Ansprüche, **dadurch gekennzeichnet, dass** die Diode eine Leuchtanzeige eines taktilen Schalters bildet, der bezüglich der Fläche F3 abgesetzt ist und sich gegenüber der die Leuchtanzeige bildenden Diode befindet, wobei sich die die Leuchtanzeige bildende Diode vorzugsweise auf dem Diodenträger befindet, der zwischen der Fläche F2 und der Fläche FA Dioden der genannten Anordnung aufweist.

14. Fahrzeug, aufweisend mindestens ein beleuchtetes Verbundglasschiebedach nach einem der vorstehenden Ansprüche.

15. Verfahren zum Herstellen des beleuchteten Verbundglasschiebedachs nach einem der vorstehenden Ansprüche des Dachs, **dadurch gekennzeichnet, dass** es die folgenden Schritte aufweist:
- Zuschneiden eines einzelnen insbesondere akustischen und/oder getönten PVB-Blatts oder einer Verbundfolie PVB/eine optionale funktionelle Beschichtung tragende funktionelle Kunststofffolie oder PVB/eine optionale funktionelle Beschichtung tragende funktionelle Kunststofffolie/PVB mit einer Dicke von vorzugsweise höchstens 0,9 mm, sodass eine oder mehrere lokale Durchgangsöffnungen oder Sacklöcher, und zwar so viele lokale Öffnungen wie Dioden, ausgebildet werden,
- Zusammensetzten der Verbundverglasung, wobei die Dioden vor der Laminierung in den Öffnungen, die breiter als die Dicke der Dioden sind, aufgenommen werden.

16. Verfahren zum Herstellen des beleuchteten Verbundglasschiebedachs nach dem vorstehenden Anspruch, **dadurch gekennzeichnet, dass** die Öffnungen Sacklöcher sind, wobei jede Öffnung in einem der PVB der Verbundfolie PVB/die funktionelle Beschichtung tragende funktionelle Kunststofffolie/PVB ausgebildet sind, ohne die funktionelle Beschichtung oder sogar die funktionelle Kunststofffolie zu berühren.

17. Verfahren zum Herstellen des beleuchteten Verbundglasschiebedachs nach einem der Ansprüche 15 bis 16, **dadurch gekennzeichnet, dass** die Dioden (4) Komponenten sind, die auf einer Oberfläche, vorzugsweise einer als Vorderfläche bezeichneten Fläche, die bezüglich der Fläche F3 des biegsamen Diodenträgers (3) oder, falls die Diode(n) eine entgegengesetzte Anbringung aufweist/aufweisen, bezüglich der Fläche F2 ausgerichtet ist, insbesondere einer vorzugsweise transparenten Kunststofffolie, angebracht sind, wobei die Vorderfläche an dem PVB des Blattes oder der Verbundfolie mit den Durchgangsöffnungen oder Sacklöchern anliegt und der Diodenträger vorzugsweise über den Rand der Verbundverglasung, insbesondere den Anschlussabschnitt, hinausragt.

18. Verfahren zum Herstellen des beleuchteten Verbundglasschiebedachs nach dem vorstehenden Anspruch, **dadurch gekennzeichnet, dass** das Blatt oder die Verbundfolie eine erste Folie ist und eine zweite thermoplastische Folie, vorzugsweise PVB, zwischen der rückseitigen Fläche des Diodenträgers und der Fläche F2 oder, falls die Diode(n) eine entgegengesetzte Anbringung aufweist/aufweisen, der Fläche F3 angeordnet ist.

19. Verfahren zum Herstellen des beleuchteten Verbundglasschiebedachs nach dem vorstehenden Anspruch, **dadurch gekennzeichnet, dass** die Verbundzwischenlage mit den Öffnungen, die breiter als die Dioden sind, sich durch Kriechen ausdehnt, bis sie den Rand der Dioden berührt, und dass sie sich gegebenenfalls bei jeder Durchgangsöffnung ausdehnt, bis sie zwischen der Vorderfläche der Hülle der Diode und der Fläche F3 ist, ohne die Emitterfläche des Chips zu berühren.

## Claims

1. A luminous laminated glazed roof for a vehicle and in particular an automobile (1000), said roof comprising:
- a laminated glazing including:
- a first transparent glazing (1), made of optionally tinted mineral glass, with main faces (11, 12) called faces F1 and F2; which glazing is intended to be the exterior glazing;
- a second transparent glazing (1') made of optionally tinted mineral glass, with main faces (13, 14) called faces F3 and F4, which glazing is intended to be the interior glazing;
- between the faces F2 and F3, which are the internal faces of the laminated glazing, an optionally tinted transparent lamination interlayer film (2, 20) made of thermoplastic polymeric material, this lamination interlayer film having a main face FA face F2 side and a main face FB face F3 side; and
- a set of N >1 inorganic light-emitting diodes (4), each diode including at least one semiconductor chip (41), each diode being able to emit in the direction of the face F3;
**characterized in that** said lamination interlayer is provided, between the face FA and the face FB, with a set of M>1 apertures that are through apertures (20a) or that form blind holes (20i), each diode being of sub-millimeter-sized thickness e2 and being housed in a through aperture or a blind hole;
**in that** each diode is associated with a through aperture or a blind hole encircling the edge face of the diode,
**in that** a flexible diode carrier (3) is pressed against or adhesively bonded to the face F2 or the face F3, the diodes being reverse-mount diodes, said diode carrier being of thickness e'2 that is submillimetric and at most 0.2 mm

2. The vehicular luminous laminated glazed roof as claimed in the preceding claim, **characterized in that** each diode is an electronic component (40) equipped with an in particular polymeric or ceramic peripheral package (42) encapsulating the edge face of the electronic component, said package in particular defining the edge face of the diode and protruding with respect to and surrounding the semiconductor chip.

3. The vehicular luminous luminous laminated glazed roof as claimed in either one of the preceding claims, **characterized in that** the flexible diode carrier (3) is of thickness e'2 that is at most 0.1 mm, and **in that** the diode carrier extends beyond the edge face of the laminated glazing and in particular includes a first portion (31) bearing the diodes, and a narrower electrical supply portion (32) extending beyond the edge face of the laminated glazing.

4. The vehicular luminous laminated glazed roof as claimed in any preceding claims, **characterized in that** the diode carrier (3) includes a diode-bearing first portion (31) that is apertured.

5. The vehicular luminous laminated glazed roof according as claimed in one of claims 3 to 4, **characterized in that** it comprises a sheet made of thermoplastic material, preferably PVB, between the back face of the diode carrier and the face F2 or the face F3, the diodes being reverse-mount diodes, said sheet preferably having a thickness of at most 0.4 mm.

6. The vehicular luminous laminated glazed roof as claimed in one of the preceding claims, **characterized in that** the through aperture or the blind hole is in a thickness of PVB.

7. The vehicular luminous laminated glazed roof as claimed in one of the preceding claims, **characterized in that** the through aperture or the blind hole is in a thickness of an acoustic lamination interlayer, in particular an acoustic and/or tinted PVB interlayer, and in particular a tinted PVB interlayer.

8. The vehicular luminous laminated glazed roof as claimed in one of the preceding claims, **characterized in that** the through aperture or the blind hole is in a composite material consisting of: a PVB sheet/transparent plastic film or even of a PVB sheet/transparent plastic film/PVB sheet, said plastic film, in particular a PET film, of sub-millimeter-sized thickness that is in particular at most 0.15 mm or even at most 0.05 mm, preferably bearing an in particular transparent, low-emissivity or solar control and/or even heating functional coating, in particular an especially transparent electrically conductive layer, the functional coating in particular being unapertured and the plastic film even being unapertured, the plastic film in particular being between the functional coating and the blind hole.

9. The vehicular luminous laminated glazed roof as claimed in any one of the preceding claims, **characterized in that** the diode carrier (3) includes a transparent film made of plastic material, preferably of polyethylene terephthalate or of polyamide, and the electrical circuit is provided with preferably transparent conductive tracks, the front face of the diode carrier in particular being against the lamination interlayer with the one or more blind or through apertures, in particular against face FA or against face FB, the diodes being reverse-mount diodes.

10. The vehicular luminous laminated glazed roof as claimed in one of the preceding claims, **characterized in that** a diode carrier (3) extends at least as far as to the edge face (10) of the laminated glazing and preferably extends beyond the edge face, in particular the electrical connection portion, and between the back face (30') of the diode carrier and the face F2 or the face F3, the diodes being reverse-mount diodes, is housed an adhesive that is impermeable to liquid water (6), of thickness of at most 0.1 mm and better still at most 0.05 mm, in particular a double-sided adhesive.

11. The vehicular luminous laminated glazed roof as claimed in one of the preceding claims, **characterized in that** the diode carrier (3) essentially covers the faces F2 and F3 and preferably bears an in particular transparent, low-emissivity or solar-control and/or even heating, functional coating and is of thickness e'2 that is preferably at most 0.15 mm and even at most 0.1 mm and preferably the diode carrier extends beyond the edge face of the laminated glazing, in particular the electrical connection portion.

12. The vehicular luminous laminated glazed roof as claimed in one of the preceding claims, **characterized in that** diodes of said set form a reading light and are preferably in a through apertures and/or on a diode carrier between face F2 and face FA.

13. The vehicular luminous laminated glazed roof as claimed in one of the preceding claims, **characterized in that** the diode forms an indicator light of a remote, touch on/off switch face F3 side and facing the diode forming the indicator light, the diode forming said indicator light preferably being on the diode carrier including diodes of said set between the face F2 and the face FA.

14. A vehicle including at least one luminous laminated glazed roof as claimed in any one of the preceding claims.

15. A process for manufacturing the luminous laminated glazed roof as claimed in one of the preceding roof claims, **characterized in that** it includes the following steps:
- cutting a single leaf of in particular acoustic and/or tinted PVB or a composite sheet consisting of a PVB sheet/film of functional plastic bearing an optional functional coating or of a PVB sheet/film of functional plastic bearing an optional functional coating/PVB sheet, said leaf or composite sheet preferably being at most 0.9 mm in thickness, to form one or more local blind or through apertures, as many local apertures as there are diodes,;
- assembling the laminated glazing, with the diodes housed in the one or more apertures, which are preferably larger than the size of the diodes before the lamination.

16. The process for manufacturing the luminous laminated glazed roof as claimed in the preceding claim, **characterized in that** the apertures are blind, each aperture being produced in one of the PVB sheets of the composite sheet consisting of a PVB sheet/plastic functional film bearing the functional coating/PVB sheet without touching said functional coating or even the plastic functional film.

17. The process for manufacturing the luminous laminated glazed roof as claimed in one of claims 15 to 16, **characterized in that** the diodes (4) are surface mount devices that are preferably mounted on what is called a front face oriented face F3 side of the flexible, diode carrier (3) or face F2 side if the diodes are reverse-mount diodes, in particular a preferably transparent plastic film, with the front face placed against the PVB of the leaf or of the composite sheet with the blind or through apertures, the diode carrier preferably extending beyond the edge face of the laminated glazing, in particular the electrical connection portion.

18. The process for manufacturing the luminous laminated glazed roof as claimed in the preceding claim, **characterized in that** the leaf or the composite sheet is a first sheet and a thermoplastic second sheet preferably of PVB is between the back face of the diode carrier and face F2 or face F3 if the one or more diodes are reverse-mount diodes.

19. A process for manufacturing the luminous laminated glazed roof as claimed in the preceding claim, **characterized in that**, by reflow, the lamination interlayer with the apertures that are wider than the diodes spreads as far as to make contact with the edge face of the diodes and **in that** optionally, for each through aperture, spreads as far as to be between said front surface of the package of the diode and the face F3 without however spreading as far as to make contact with the emitting face of the chip.
